# FASCICULE DE BREVET EUROPEEN

(11) **EP 2 795 668 B1**
(45) Date de publication et mention de la délivrance du brevet: **15.11.2017**
(21) Numéro de dépôt: 12816756.6
(22) Date de dépôt: 20.12.2012
(51) Int. Cl.: H01L 21/28, H01L 29/51, H01L 29/16, H01L 29/49

(54) **PROCEDE DE FABRICATION D'UN EMPILEMENT MOS SUR UN SUBSTRAT EN DIAMANT**
VERFAHREN ZUR HERSTELLUNG EINES MOS-STAPELS AUF EINEM DIAMANTSUBSTRAT
METHOD FOR PRODUCING A MOS STACK ON A DIAMOND SUBSTRATE

(30) Priorité: 20.12.2011 FR 1162052
(43) Date de publication de la demande: 29.10.2014
(73) Titulaire: Centre National de la Recherche Scientifique (C.N.R.S.), 75794 Paris Cedex 16 (FR); Université Joseph Fourier, 38041 Grenoble Cedex 9 (FR)
(72) Inventeur: CHICOT, Gauthier, F-38100 Grenoble (FR); MARECHAL, Aurélien, F-38400 St Martin d'Heres (FR); MURET, Pierre, F-38410 Saint Martin d'Uriage (FR); PERNOT, Julien, F-38000 Grenoble (FR)
(74) Mandataire: Thibon, Laurent
(86) Numéro de dépôt international: PCT/FR2012/053026
(87) Numéro de publication internationale: WO 2013/093360

(56) Documents cités:
- JP-A- 2007 051 327
- JP-A- 2011 168 460
- KAWAKAMI N ET AL: "Atomic layer deposition of Al2O3 thin films on diamond", DIAMOND AND RELATED MATERIALS, ELSEVIER SCIENCE PUBLISHERS, AMSTERDAM, NL, vol. 14, no. 11-12, 1 novembre 2005 (2005-11-01), pages 2015-2018, XP027813527, ISSN: 0925-9635 [extrait le 2005-11-01]
- KUECK D ET AL: "Analysis of passivated diamond surface channel FET in dual-gate configuration - Localizing the surface acceptor", DIAMOND AND RELATED MATERIALS, ELSEVIER SCIENCE PUBLISHERS, AMSTERDAM, NL, vol. 19, no. 2-3, 1 février 2010 (2010-02-01), pages 166-170, XP026877176, ISSN: 0925-9635 [extrait le 2009-09-30]
- TERAJI T ET AL: "Low-leakage p-type diamond Schottky diodes prepared using vacuum ultraviolet light/ozone treatment", JOURNAL OF APPLIED PHYSICS, AMERICAN INSTITUTE OF PHYSICS. NEW YORK, US, vol. 105, no. 12, 25 juin 2009 (2009-06-25), pages 126109-126109, XP012125805, ISSN: 0021-8979, DOI: 10.1063/1.3153986 cité dans la demande
- YOSHIKATSU JINGU ET AL: "Ultrashallow TiC Source/Drain Contacts in Diamond MOSFETs Formed by Hydrogenation-Last Approach", IEEE TRANSACTIONS ON ELECTRON DEVICES, IEEE SERVICE CENTER, PISACATAWAY, NJ, US, vol. 57, no. 5, 1 mai 2010 (2010-05-01), pages 966-972, XP011307277, ISSN: 0018-9383

## Description

### Domaine de l'invention

La présente invention concerne la réalisation de composants électroniques dans et sur des substrats en diamant monocristallin. Elle vise plus particulièrement la réalisation d'un empilement métal-oxyde-semiconducteur (MOS) dans lequel le matériau semiconducteur est du diamant monocristallin.

### Exposé de l'art antérieur

On a déjà proposé de réaliser des composants électroniques, par exemple des diodes Schottky, en utilisant du diamant monocristallin dopé comme matériau semiconducteur. Le diamant présente en effet des propriétés physiques et électroniques qui le rendent particulièrement intéressant, notamment pour des applications de forte puissance.

Une limitation majeure à l'utilisation du diamant dans des composants semiconducteurs est que les procédés de fabrication connus ne permettent pas de réaliser une structure métal-oxyde-diamant apte à fonctionner en régime d'inversion, c'est-à-dire dans laquelle l'application d'un potentiel convenablement choisi sur la grille provoque une inversion du type de porteurs de charge majoritairement présents dans la région de diamant située sous la grille.

Il en résulte qu'à ce jour, les composants électroniques dont le fonctionnement utilise le régime d'inversion, par exemple les transistors MOS, ne peuvent pas être réalisés sur des substrats semiconducteurs en diamant.

Le document JP2007/051327 et l'article intitulé "Atomic layer deposition of Al2O3 thin films on diamond" de Kawakami N et al. (DIAMOND AND RELATED MATERIALS, ELSEVIER SCIENCE PUBLISHERS, AMSTERDAM, NL, vol. 14, no. 11-12, 1 novembre 2005) décrivent des exemples de proceed de realization d'un empilement métal-oxyde-diamant.

### Résumé

Ainsi, un objet d'un mode de réalisation de la présente invention est de prévoir un procédé permettant de fabriquer, dans et sur un substrat diamant monocristallin, une structure MOS apte à fonctionner en régime d'inversion.

Un mode de réalisation de la présente invention prévoit un procédé selon l'une quelconque des revendications 1 à 6 et un composant selon la revendication 7.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
La figure 1 est une vue en coupe représentant de façon schématique un exemple d'une structure MOS réalisée dans et sur un substrat en diamant ;
les figures 2A à 2D sont des vues en coupe illustrant de façon schématique des étapes d'un procédé de réalisation, dans et sur un substrat en diamant, d'une structure MOS apte à fonctionner en régime d'inversion ; et
la figure 3 est un diagramme représentant l'évolution de la capacité d'une structure MOS réalisée selon le procédé des figures 2A à 2D, en fonction de la tension appliquée.

### Description détaillée

Comme cela est habituel dans la représentation des circuits intégrés, les diverses figures ne sont pas tracées à l'échelle.

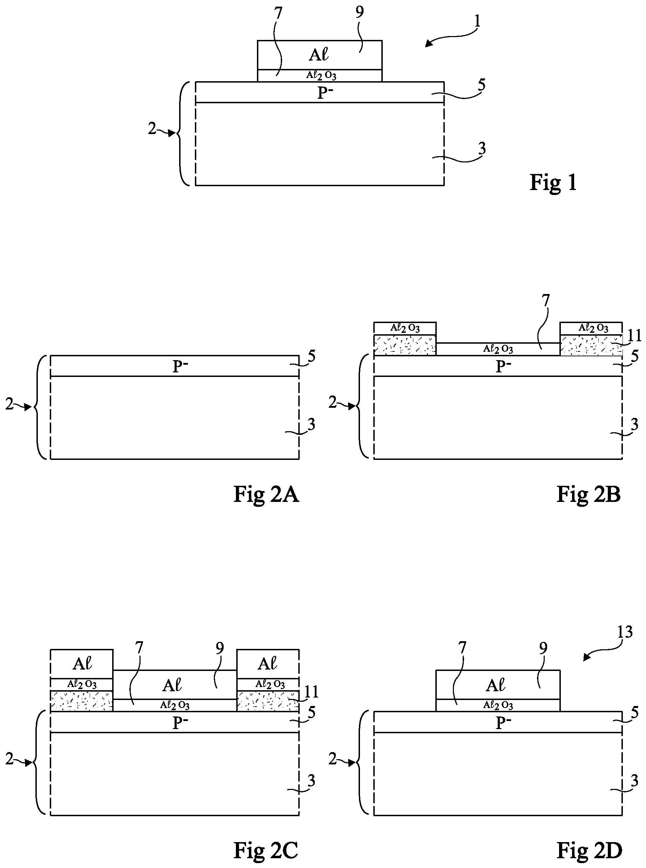

La figure 1 représente de façon schématique une structure MOS 1 réalisée dans et sur un substrat 2 en diamant. Dans cet exemple, le substrat 2 comprend un support 3 en diamant monocristallin, dont la face supérieure est revêtue d'une couche de diamant épitaxiée 5, faiblement dopée de type P (P⁻). Une partie de la face supérieure de la couche épitaxiée 5, est revêtue d'une région isolante 7, par exemple en oxyde d'aluminium (Al₂O₃). La région d'oxyde 7 est elle-même revêtue d'une électrode métallique 9, ou grille, par exemple en aluminium (Al). L'empilement de la grille 9, de la région isolante 7 et du diamant semiconducteur 5 forme une structure MOS.

Jusqu'à présent, toutes les tentatives menées par les acteurs du domaine des composants électroniques en diamant pour inverser la partie d'une couche de diamant dopée d'un certain type de conductivité située sous une grille isolée, se sont soldées par des échecs.

Des études menées par les inventeurs semblent montrer que les états de surface à l'interface entre l'oxyde et le diamant pourraient empêcher que des porteurs de charge minoritaires s'accumulent dans la région superficielle de substrat située sous la grille jusqu'à devenir majoritaires. En particulier, dans le cas où le substrat est de type P, les inventeurs ont constaté que l'application d'une tension positive entre la grille et le substrat conduit bien à attirer des électrons vers la grille, mais que ces électrons sont piégés à l'interface entre l'oxyde et le diamant, ce qui empêche leur accumulation dans la région superficielle du substrat située sous la grille, et donc l'inversion du type de porteurs de charge majoritairement présents dans cette région. Si on augmente la tension positive appliquée entre la grille et le substrat, l'oxyde 7 finit par claquer avant qu'il ne soit possible d'obtenir une accumulation significative d'électrons libres (non piégés à l'interface) dans la région superficielle de substrat située sous l'oxyde de grille.

Les figures 2A à 2D sont des vues en coupe illustrant de façon schématique des étapes d'un mode de réalisation d'un procédé de fabrication, dans et sur un substrat semiconducteur en diamant, d'une structure MOS apte à fonctionner en inversion. De mêmes éléments sont désignés par de mêmes références en figures 2A à 2D et en figure 1.

La figure 2A illustre une structure de départ comportant un substrat 2 comprenant un support 3 de diamant monocristallin revêtu d'une couche épitaxiée 5 de diamant dopé de type P. Le support 3 est par exemple en diamant naturel taillé, ou en diamant synthétique obtenu par croissance à haute pression et haute température, par dépôt chimique en phase vapeur, ou par toute autre technique connue. L'épaisseur du support 3 est par exemple comprise entre 300 et 700 µm. La couche épitaxiée 5 est par exemple obtenue par dépôt chimique en phase vapeur assisté par plasma en présence d'un rayonnement micrométrique, selon une technique désignée dans la technique par le sigle MPCVD, de l'anglais "Microwave Plasma Chemical Vapor Déposition". L'épaisseur de la couche 5 est par exemple comprise entre 0,1 et 50 µm.

Avant de former l'isolant de grille de la structure MOS, on prévoit une étape d'oxygénation de la surface supérieure de la couche 5. A titre d'exemple, la structure est placée dans une enceinte sous vide, puis on introduit de l'oxygène dans l'enceinte, et la surface supérieure de la couche 5 est irradiée par un rayonnement ultraviolet. Ceci conduit à remplacer les terminaisons hydrogène de la surface supérieure de la couche de diamant 5 par des terminaisons oxygène. Un tel procédé d'oxygénation, connu en lui-même, est par exemple décrit dans l'article de T. Teraji et al, paru au Journal of Applied Physics 105, 126109 (2009*).* On notera que, par enceinte sous vide, on entend ici une enceinte dans laquelle la pression est inférieure à la pression atmosphérique, par exemple de l'ordre de 10⁻⁵ millibars. Lorsque l'oxygène est présent dans l'enceinte, la pression dans l'enceinte est par exemple de l'ordre de 0,4 millibars. A titre d'exemple, la durée d'exposition de la structure à l'oxygène et au rayonnement ultraviolet est comprise entre 1h et 3h. L'étape d'oxygénation peut se faire à température ambiante.

Plus généralement, tout autre procédé d'oxygénation apte à remplacer des terminaisons de surface hydrogène du diamant par des terminaisons de surface oxygène pourra être utilisé, par exemple un procédé d'oxygénation par plasma.

La figure 2B illustre une étape de formation d'une région isolante 7 en oxyde d'aluminium sur la surface supérieure préalablement oxygénée de la couche de diamant 5. Préalablement, un masque 11 a été formé, délimitant la ou les régions du substrat où l'on souhaite déposer l'oxyde d'aluminium. La région 7 est formée par dépôt en couches monoatomiques successives, par un procédé habituellement désigné dans la technique par le sigle ALD, de l'anglais "Atomic Layer Déposition". Dans un exemple de réalisation, la formation de chaque couche monoatomique d'oxyde d'aluminium comprend une étape de mise en contact de la surface à revêtir avec une atmosphère comprenant du triméthyl-aluminium, suivie d'une étape de purge, puis d'une étape de mise en contact de la surface avec une atmosphère comprenant de la vapeur d'eau, et d'une nouvelle étape de purge. La température de dépôt est par exemple comprise entre 100 et 200°C. Dans cet exemple, l'épaisseur d'oxyde d'aluminium déposée est d'environ 10 nm.

Plus généralement, la région isolante 7 pourra être réalisé en d'autres matériaux que l'oxyde d'aluminium, dans la mesure où ces matériaux peuvent être déposés en couches monoatomiques successives (ALD) à la surface du diamant. Si un autre matériau que l'oxyde d'aluminium est utilisé, l'homme du métier saura choisir des précurseurs adaptés pour réaliser le dépôt.

En pratique, le dépôt d'oxyde (figure 2B) est réalisé dans une enceinte différente de l'enceinte utilisée pour réaliser l'oxygénation de la surface du diamant (figure 2A). Le diamant monocristallin présente l'avantage que ses terminaisons de surface, qu'elles soient hydrogène ou oxygène, sont très stables une fois modifiées, et ce jusqu'à des températures d'au moins 450°C. En particulier, elles supportent sans modification l'exposition à l'air. Le transfert du substrat d'une enceinte à une autre lors des différentes étapes de procédé ne pose donc pas de problème particulier.

La figure 2C illustre une étape de formation d'une grille 9 sur la surface supérieure de la couche d'oxyde d'aluminium 7. La grille 9 est par exemple en aluminium, et peut être réalisée par évaporation d'aluminium par canon à électrons et condensation sur la surface à revêtir, ou par toute autre méthode connue. Dans l'exemple représenté, le même masque 11, précédemment utilisé pour délimiter la région d'oxyde d'aluminium 7, est utilisé pour délimiter la région de grille 9. Dans cet exemple, l'épaisseur de la grille 9 est d'environ 100 nm.

La figure 2D illustre une étape de retrait du masque 11, à l'issue de laquelle on obtient une structure MOS 13 comprenant les mêmes éléments que la structure MOS 1 de la figure 1.

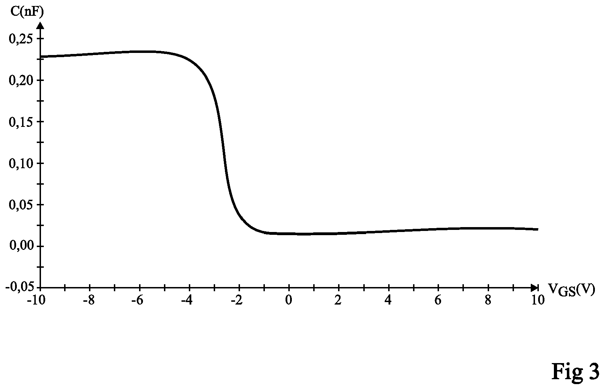

Comme cela apparaît sur la figure 3 qui sera décrite plus en détail ci-après, une caractéristique fondamentale de la structure MOS 13 de la figure 2D est qu'elle est apte à fonctionner en inversion, c'est-à-dire que lorsqu'un potentiel positif est appliqué à la grille 9, des électrons s'accumulent dans la région superficielle de la couche 5 située sous la grille 9, jusqu'à devenir majoritaires par rapport aux trous dans cette région. En d'autres termes, dans la structure MOS 13 de la figure 2D, une région superficielle de la couche 5 située sous la grille 9 est inversable.

Ce fonctionnement est rendu possible par la qualité de l'interface entre l'oxyde et le diamant, obtenue en combinant l'utilisation d'une étape d'oxygénation des terminaisons de surface du diamant 5 préalablement à la formation de la région d'oxyde 7, et l'utilisation d'une technique de dépôt en couches minces monoatomiques (ALD) pour former la région d'oxyde 7.

La figure 3 est un diagramme représentant l'évolution de la capacité C en nanofarads (nF) de la structure MOS 13 de la figure 2D, en fonction de la tension V_{GS} en volts (V) appliquée entre la grille 9 et la couche semiconductrice 5. Pour effectuer les mesures, une électrode périphérique, non représentée, est prévue pour prendre un contact ohmique sur la couche 5.

Pour une tension V_{GS} négative, par exemple comprise entre -10 et -4 V, la structure MOS fonctionne en régime d'accumulation, c'est-à-dire que des trous (porteurs de charge majoritaires dans la couche 5 de type P) s'accumulent dans la région de la couche 5 située sous la grille 9. Il en résulte une augmentation de la conductivité électrique de la couche 5 dans cette région. Les mesures effectuées par les inventeurs montrent que la capacité de la structure MOS 13 est alors directement liée à l'épaisseur de la couche d'oxyde 7 selon la relation C = ε*S/d, où ε est la permittivité diélectrique de l'oxyde d'aluminium, S la surface de la grille 9, et d l'épaisseur de la région d'oxyde d'aluminium.

Lorsque la tension V_{GS} dépasse un premier seuil, par exemple de l'ordre de -2 V dans cet exemple, les mesures effectuées par les inventeurs montrent une nette diminution de la capacité de la structure MOS 13. Cette diminution de capacité indique que la région de diamant monocristallin située sous la grille 9 s'appauvrit en porteurs majoritaires, c'est-à-dire en trous. Il s'agit du régime de déplétion. La couche déplétée se comporte comme une épaisseur isolante supplémentaire (en plus de l'épaisseur d'oxyde d'aluminium 7) entre la grille 9 et la région conductrice de la couche 5.

Lorsque la tension V_{GS} dépasse un second seuil supérieur au premier seuil, par exemple de l'ordre de 0 V dans cet exemple, la capacité se stabilise, ce qui signifie que l'épaisseur de la zone déplétée cesse de croître, et que la région superficielle de diamant située sous la grille 9 s'inverse.

On remarquera en observant la courbe de la figure 3 que dans cet exemple, l'appauvrissement (chute de capacité de la structure MOS) se produit dès qu'une tension V_{GS} supérieure à environ -2 V est appliquée, c'est-à-dire avant même qu'une tension positive soit appliquée entre la grille et le substrat. Ce phénomène s'explique par la différence de travail de sortie existant entre l'aluminium de la grille 9 et le diamant semiconducteur de la couche 5.

Un avantage de la structure MOS obtenue par le procédé décrit en relation avec les figures 2A à 2D est qu'une conductivité minimale peut être obtenue dans la région superficielle de diamant située sous la grille (par exemple la région de canal d'un transistor MOS) pour une tension de grille approximativement nulle. Il est donc possible, pour obtenir l'état passant, de choisir soit un fonctionnement en accumulation (tension négative sur la grille) soit un fonctionnement en inversion (tension positive sur la grille).

Des modes de réalisation particuliers de la présente invention ont été décrits. Diverses variantes et modifications apparaîtront à l'homme de l'art.

En particulier, on a décrit ci-dessus un procédé de fabrication d'un empilement MOS apte à fonctionner en régime d'inversion. L'homme de l'art saura, sans faire preuve d'activité inventive, utiliser ce procédé, et plus particulièrement les étapes d'oxygénation des terminaisons de surface du diamant et de dépôt d'oxyde en couches monoatomiques successives (figures 2A et 2B), pour fabriquer tout composant MOS susceptible de devoir fonctionner en inversion, par exemple un transistor MOS. On notera cependant que le procédé proposé permet aussi bien de réaliser un transistor MOS utilisant les régimes d'accumulation et de déplétion, qu'un transistor MOS utilisant les régimes d'inversion et de déplétion.

Par ailleurs, bien que l'invention ait été décrite dans le cas où le substrat semiconducteur en diamant est de type P, l'homme de l'art saura, sans faire preuve d'activité inventive, adapter le procédé proposé à la réalisation d'un composant MOS dans et sur un substrat semiconducteur en diamant dopé de type N.

## Revendications

1. Procédé de fabrication d'un composant comportant une grille conductrice (9) isolée d'un substrat semiconducteur (2) en diamant monocristallin par une région isolante (7), comprenant les étapes suivantes :
a) oxygéner la surface du substrat (2) de façon à remplacer des terminaisons de surface hydrogène du substrat par des terminaisons de surface oxygène ; et
b) former la région isolante (7) à la surface du substrat (2) par dépôt en couches monoatomiques successives (ALD),
**caractérisé en ce que**, à l'étape a), le substrat (2) est placé dans une enceinte contenant du dioxygène à une pression inférieure à la pression atmosphérique, et est irradié par une lumière ultraviolette.

2. Procédé selon la revendication 1, dans lequel la région isolante (7) est en oxyde d'aluminium.

3. Procédé selon la revendication 2, dans lequel à l'étape b), la formation de chaque couche monoatomique d'oxyde d'aluminium comprend une phase de mise en contact de la surface du composant avec une atmosphère comprenant du triméthyl-aluminium, suivie d'une phase de mise en contact de la surface du composant avec une atmosphère comprenant de la vapeur d'eau.

4. Procédé selon l'une quelconque des revendications 1 à 3, dans lequel la grille (9) est en métal.

5. Procédé selon l'une quelconque des revendications 1 à 4, dans lequel la grille (9) est en aluminium.

6. Procédé selon l'une quelconque des revendications 1 à 5, dans lequel le substrat (2) comprend une couche supérieure épitaxiée (5) en diamant monocristallin dopé de type P.

7. Composant susceptible d'être obtenu par un procédé de fabrication selon l'une quelconque des revendications 1 à 6, comportant un substrat semiconducteur (2) en diamant monocristallin dopé revêtu d'une grille conductrice (9) isolée par une région isolante (7), dans lequel une région superficielle de substrat située sous la grille est inversable.

## Patentansprüche

1. Verfahren zur Herstellung einer Komponente, die ein leitendes Gatter bzw.
Gate (9) aufweist, welches von einem einkristallinen Diamantenhalbleitersubstrat (2) durch einen isolierenden Bereich (7) isoliert ist, welches folgende Schritte aufweist:
a) Oxygenieren der Oberfläche des Substrates (2), um Wasserstoffoberflächenterminierungen des Substrates mit Sauerstoffoberflächenterminierungen zu ersetzen; und
b) Formen des isolierenden Bereiches (7) an der Oberfläche des Substrates (2) durch Atomlagenabscheidung (ALD = atomic layer deposition),
**dadurch gekennzeichnet, dass** im Schritt a) das Substrat (2) in einer Umhüllung angeordnet wird, welche zwei-atomigen Sauerstoff bei einem Druck von weniger als dem atmosphärischen Druck enthält, und mit ultraviolettem Licht bestrahlt wird.

2. Verfahren nach Anspruch 1, wobei der isolierende Bereich (7) aus Aluminiumoxyd gemacht ist.

3. Verfahren nach Anspruch 2, wobei im Schritt b) das Formen von jeder Atommonoschicht von Aluminiumoxyd eine Phase aufweist, bei der die Komponentenoberfläche mit einer Atmosphäre in Kontakt gebracht wird, welche Trimethylaluminium aufweist, gefolgt durch eine Phase bei der die Komponentenoberfläche mit einer Atmosphäre in Kontakt gebracht wird, die Wasserdampf aufweist.

4. Verfahren nach einem der Ansprüche 1 bis 3, wobei das Gate (9) aus Metall gemacht ist.

5. Verfahren nach einem der Ansprüche 1 bis 4, wobei das Gate (9) aus Aluminium gemacht ist.

6. Verfahren nach einem der Ansprüche 1 bis 5, wobei das Substrat (2) eine obere epitaxiale Schicht (5) aufweist, die aus P-dotiertem einkristallinen Diamant gemacht ist.

7. Komponente, die durch das Herstellungsverfahren nach einem der Ansprüche 1-6 erhalten werden kann, welche ein Halbleitersubstrat (2) aufweist, welches aus dotiertem einkristallinen Diamant beschichtet mit einem leitenden Gate (9) gemacht ist, das durch einen isolierenden Bereich (7) isoliert ist, wobei ein Oberflächenbereich des Substrates, der unter dem Gate angeordnet ist, invertierbar ist.

## Claims

1. A method of manufacturing a component comprising a conductive gate (9) insulated from a single-crystal diamond semiconductor substrate (2) by an insulating region (7), comprising the steps of:
a) oxygenating the surface of the substrate (2) to replace hydrogen surface terminations of the substrate with oxygen surface terminations; and
b) forming the insulating region (7) at the surface of the substrate (2) by atomic layer deposition (ALD),
**characterized in that**, at step a), the substrate (2) is placed in an enclosure containing dioxygen at a pressure lower than the atmospheric pressure, and is irradiated with ultraviolet light.

2. The method of claim 1, wherein the insulating region (7) is made of aluminum oxide.

3. The method of claim 2, wherein, at step b), the forming of each atom monolayer of aluminum oxide comprises a phase of placing into contact the component surface with an atmosphere comprising trimethyl-aluminum, followed by a phase of placing into contact the component surface with an atmosphere comprising water vapor.

4. The method of any of claims 1 to 3, wherein the gate (9) is made of metal.

5. The method of any of claims 1 to 4, wherein the gate (9) is made of aluminum.

6. The method of any of claims 1 to 5, wherein the substrate (2) comprises an upper epitaxial layer (5) made of P-type doped single-crystal diamond.

7. A component capable of being obtained by the manufacturing method of any of claims 1 to 6, comprising a semiconductor substrate (2) made of doped single-crystal diamond coated with a conductive gate (9) insulated by an insulating region (7), wherein a surface region of the substrate located under the gate is invertible.
